# FASCICULE DE BREVET EUROPEEN

(11) **EP 0 362 080 B1**
(45) Date de publication et mention de la délivrance du brevet: **03.11.1993**
(21) Numéro de dépôt: 89420315.7
(22) Date de dépôt: 28.08.1989
(51) Int. Cl.: H03K 17/687

(54) **Commutateur bidirectionnel monolithique à transistors MOS de puissance**
Monolithischer Zweiwegschalter mit MOS-Leistungstransistoren
Monolithic bidirectional switch with MOS power transistors

(30) Priorité: 31.08.1988 FR 8811658
(43) Date de publication de la demande: 04.04.1990
(73) Titulaire: SGS-THOMSON MICROELECTRONICS S.A., 94250 Gentilly (FR)
(72) Inventeur: Nadd, Bruno, F-84160 Lourmarin par Cadenet (FR)
(74) Mandataire: de Beaumont, Michel

(56) Documents cités:
- DE-A- 3 133 518
- FR-A- 2 373 195
- GB-A- 2 158 314
- US-A- 3 740 581
- US-A- 4 480 201

## Description

La présente invention concerne le domaine des commutateurs bidirectionnels de puissance. Elle vise plus particulièrement un nouveau type de commutateur bidirectionnel de puissance monolithique.

Dans la technique, le seul commutateur bidirectionnel monolithique à semiconducteur existant est le triac dont les avantages et les inconvénients sont bien connus. Rappelons toutefois parmi les inconvénients le fait qu'un triac n'est blocable simplement que lors du passage par zéro du courant qui le traverse. Il n'est donc pas possible de bloquer un triac en cas de court-circuit dans la charge.

Ainsi, dans de nombreuses applications, étant donné les inconvénients du triac, on est amené à utiliser comme commutateur bidirectionnel des dispositifs non-monolithiques comprenant par exemple : un thyristor ou un transistor MOS ou bipolaire de puissance disposé dans un pont redresseur ; un ensemble de deux transistors bipolaires de puissance reliés par leurs collecteurs ; ou un ensemble de deux transistors MOS de puissance reliés par leurs sources.

Le document DE-A-3133518 concerne une combinaison de transistors MOS constituant un commutateur statique bidirectionnel, tel que défini au préambule de la revendication indépendante.

Un objet de la présente invention est de prévoir un nouveau type de commutateur bidirectionnel monolithique utilisant des transistors MOS de puissance avec tous les avantages qui leur sont liés, ce commutateur bidirectionnel pouvant être ouvert à tout instant quel que soit le courant qui le traverse ou l'état de la tension à ses bornes.

Ces objets, caractéristiques et avantages de la présente invention sont atteints à l'aide d'un commutateur statique de puissance bidirectionnel réalisé sous forme monolithique, comprenant deux transistors de puissance principaux à conduction en inverse reliés par leurs premières électrodes principales non-référencées à leurs bornes de commande et dont les deuxièmes électrodes principales référencées à leurs bornes de commande constituent les bornes principales du commutateur, et deux transistors MOS auxiliaires dont chacun est connecté par ses bornes principales entre la deuxième borne principale et la borne de commande de chaque transistor de puissance. Les grilles de ces transistors MOS auxiliaires sont reliées à la première électrode principale commune des transistors de puissance. Deux résistances de valeur élevée sont respectivement connectées entre la borne de commande de chaque transistor de puissance et la borne de commande du commutateur statique.

La borne de commande du commutateur statique est connectée ou bien à l'une des électrodes principales pour fixer un ordre d'ouverture, ou bien à un potentiel positif par rapport à cette borne de commande pour fixer un ordre de fermeture.

Les transistors principaux sont de préférence des transistors MOS de puissance verticaux dont la première électrode principale est le drain et dont la deuxième électrode principale est la source.

Ces objets, caractéristiques et avantages ainsi que d'autres de la présente invention seront exposés plus en détail dans la description suivante d'un mode de réalisation particulier faite en relation avec les figures jointes parmi lesquelles :
les figures 1A à 1D représentent un mode de réalisation simplifié d'un commutateur de puissance bidirectionnel monolithique selon la présente invention dans quatre configurations différentes de tension aux bornes et de signal de commande appliqué ;
la figure 2 représente des chronogrammes destinés à illustrer le fonctionnement du circuit représenté en figures 1A à 1D dans diverses configurations de polarisation ;
la figure 3 représente en coupe très schématique une tranche semiconductrice illustrant un exemple de réalisation d'un commutateur bidirectionnel selon la présente invention ; et
la figure 4 illustre une variante pratique du circuit des figures 1A à 1D.

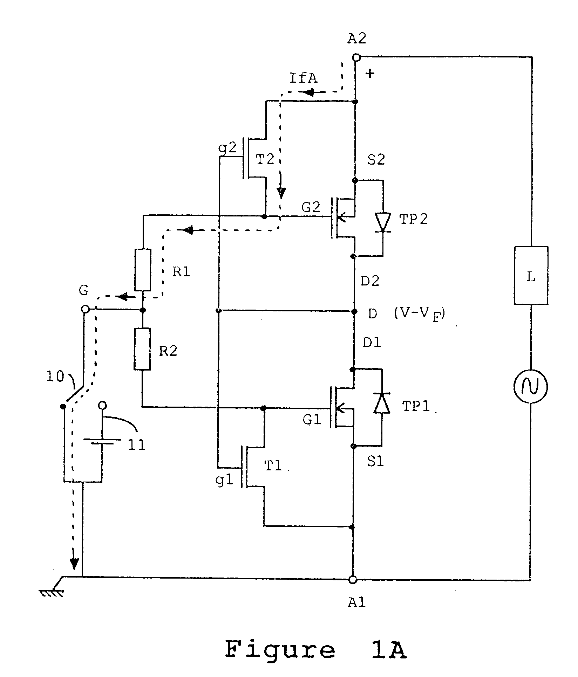

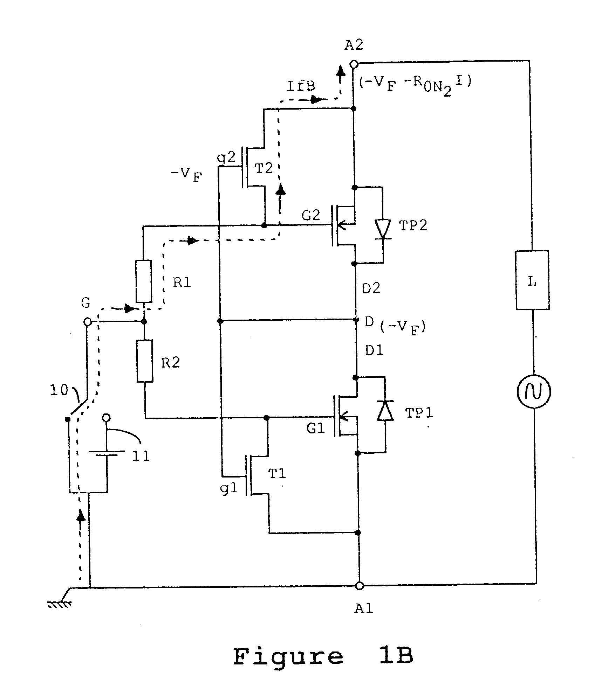

Les figures 1A à 1D illustrent un mode de réalisation particulier d'un commutateur bidirectionnel selon la présente invention. Ce commutateur comprend des bornes principales A1 et A2 et une borne de commande G. Dans toute la description ci-après, on considérera que la borne A1 est à un potentiel de référence et que la borne A2 est à un potentiel positif ou négatif par rapport à ce potentiel de référence.

Ce commutateur bidirectionnel est destiné à commander le passage du courant dans une charge L en série avec une alimentation, par exemple le réseau alternatif. La commande de ce commutateur se fait en reliant sa borne de commande G par l'intermédiaire d'un commutateur 10 ou bien au potentiel de référence ou bien à une borne 11 d'une source de tension continue, positive par rapport au potentiel de référence. L'ouverture du commutateur est déterminée par connexion au potentiel de référence et sa fermeture par connexion à la source de tension positive 11.

La partie de commutation de puissance proprement dite du commutateur bidirectionnel selon l'invention est constituée de deux transistors MOS de puissance TP1 et TP2 connectés l'un à l'autre par leurs drains, la source du transistor TP1 étant reliée à la borne A1 et la source du transistor TP2 à la borne A2.

On rappellera que, dans la réalisation classique d'un transistor MOS de puissance, par exemple un transistor MOS diffusé de type vertical, la source est la borne principale du transistor de puissance qui est reliée au caisson dans lequel est susceptible de se former un canal. Le drain est généralement constitué par la face arrière du transistor MOS de puissance, sauf dans certains cas où diverses techniques sont utilisées pour ramener le contact de drain sur la face avant. Ainsi, comme on le verra ci-après, il est relativement simple de relier deux transistors MOS de puissance par leurs drains.

On a désigné dans la figure 1A par S1 et S2 les sources des transistors TP1 et TP2, par D1 et D2 leurs drains qui portent également la référence D puisqu'ils sont communs, et par G1 et G2 leurs grilles de commande.

Chacun des transistors MOS de puissance TP1 et TP2 est représenté sous forme d'un transistor MOS proprement dit et d'une diode en parallèle conductrice de la source vers le drain, une telle diode existant dans les réalisations pratiques de transistors MOS de puissance. La source et la grille de chaque transistor MOS de puissance TP1, TP2 sont reliées par l'intermédiaire de transistors auxiliaires, respectivement T1 et T2, dont les grilles g1 et g2 sont interconnectées et reliées au drain commun D des transistors de puissance. Ces transistors T1 et T2 ne sont pas nécessairement réalisés selon la technologie des transistors de puissance et n'ont donc pas une source et un drain définis physiquement. C'est la borne au plus faible potentiel qui jouera le rôle de source et l'autre le rôle de drain. Enfin, les grilles G1 et G2 des transistors TP1 et TP2 sont reliées par des résistances de valeurs élevées, respectivement R1 et R2, à la borne de commande G du commutateur.

### FONCTIONNEMENT DU COMMUTATEUR DE PUISSANCE

### 1) Application d'un ordre d'ouverture pendant une alternance positive.

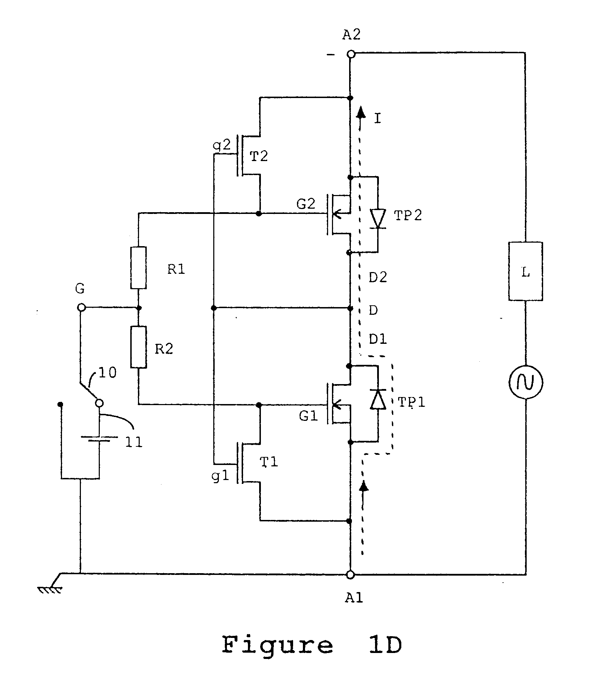

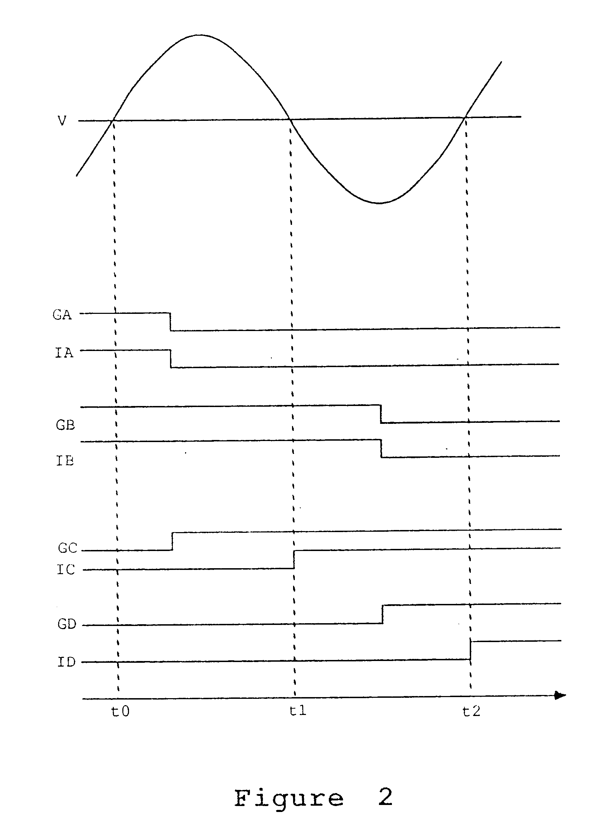

Ce fonctionnement va être exposé en relation avec la figure 1A et les courbes V, GA et IA de la figure 2. Comme le représente la figure 2, on se place entre les instants t0 et t1, pendant une alternance positive de la tension V du réseau et on suppose que, pendant cette alternance, on applique un signal GA sur la borne de commande qui passe de haut à bas niveau (d'une valeur positive au potentiel de référence).

Dans cette configuration, la borne A2 est positive par rapport à la borne A1 et, avant application de l'ordre d'ouverture, un courant de charge circule de la borne A2 à la borne A1 en passant par la diode parallèle du transistor TP2 et par le transistor TP1. A l'instant où l'on met la borne G à la tension de référence, c'est-à-dire à la tension de source de TP1, ce transistor se bloque. La tension sur le drain commun D reste égale à la tension V sur la borne A2 moins la chute de tension en direct (VF) dans la diode parallèle du transistor TP2. Cette tension V - VF est appliquée à la grille du transistor T2. La résistance R2 force un courant IfA à être extrait de la source du transistor T2 qui se polarise à V - VF - VT (VT étant la tension de seuil du transistor MOS). Ce courant IfA constitue un courant de fuite qui circule de la borne A2 à travers le transistor T2 par l'intermédiaire de la résistance R2 vers la borne G et le potentiel de référence. Il est donc nécessaire de choisir une valeur élevée pour la résistance R2 pour limiter ce courant de fuite. On pourra par exemple choisir une valeur de l'ordre du mégohm, ce qui limite le courant de fuite à 220 microampères pour une tension de 220 volts sur la borne A2. Le trajet de ce courant de fuite ifA est représenté en pointillés en figure 1A.

En résumé, comme le représente la figure 2 par la courbe IA, le commutateur se bloque sensiblement au moment de l'ordre d'ouverture.

### 2) Application d'un ordre d'ouverture pendant une alternance négative.

Ce cas est illustré en figure 1B en relation avec les courbes GB et IB de la figure 2. On suppose qu'initialement la borne A2 est négative par rapport à la borne A1 (potentiel - V) et que le système est passant, c'est-à-dire que le courant principal circule dans la diode parallèle du transistor TP1 et que le transistor TP2 est passant. Dans cet état, la tension sur la borne D est -VF (chute de tension en direct de la diode du transistor TP1) et la tension sur la borne A2 est égale à -VF - R_{ON}I, I étant le courant traversant le commutateur et R_{ON} la résistance à l'état passant du transistor TP2. Pendant cet état de conduction, la grille G2 du transistor TP2 est sensiblement au potentiel de la source d'alimentation positive de commande 11, par exemple 10 volts.

Quand on relie la borne de commande G à la masse, la tension sur la grille G2 du transistor TP2 tend à chuter, le transistor TP2 devient progressivement moins conducteur et sa résistance interne augmente. Le potentiel de la borne A2 tend à diminuer (devenir plus négatif) et en conséquence le transistor T2 dont la grille g2 reste au potentiel -VF devient passant, court-circuitant la grille et la source du transistor TP2 et parachevant son blocage. Il circule alors un courant de fuite IfB de la borne G vers la borne A2 par l'intermédiaire de la résistance R2 et du transistor T2.

Comme le montre la courbe IB, le commutateur selon l'invention passe donc à bas niveau sensiblement en même temps que la tension de grille G.

On a montré ci-dessus que le fait de mettre la borne de commande G au potentiel de référence auquel est connecté la borne A1 entraîne l'ouverture du commutateur bidirectionnel selon l'invention dans les deux cas où une alternance positive et où une alternance négative est appliquée aux bornes principales du commutateur bidirectionnel. Il donc clair qu'à partir du moment où la borne de commande G est reliée au potentiel de référence, le commutateur bidirectionnel selon l'invention s'ouvre et reste à l'état ouvert. Toutefois, de légers parasites peuvent se produire lors des passages à zéro, tandis que la tension de commande est nulle. Pour éviter ces parasites, on pourra choisir comme tension de seuil pour le transistor de puissance TP2 une tension supérieure à la tension de seuil du transistor T2 augmentée d'une chute de tension en direct (VF) de diode. Une autre solution consisterait à intercaler un dispositif de décalage de tension en série avec les grilles des transistors T1 et T2. Des moyens pour réaliser de tels dispositifs translateurs de tension sont connus de l'homme de l'art.

### 3) Application d'un ordre de fermeture pendant une alternance négative.

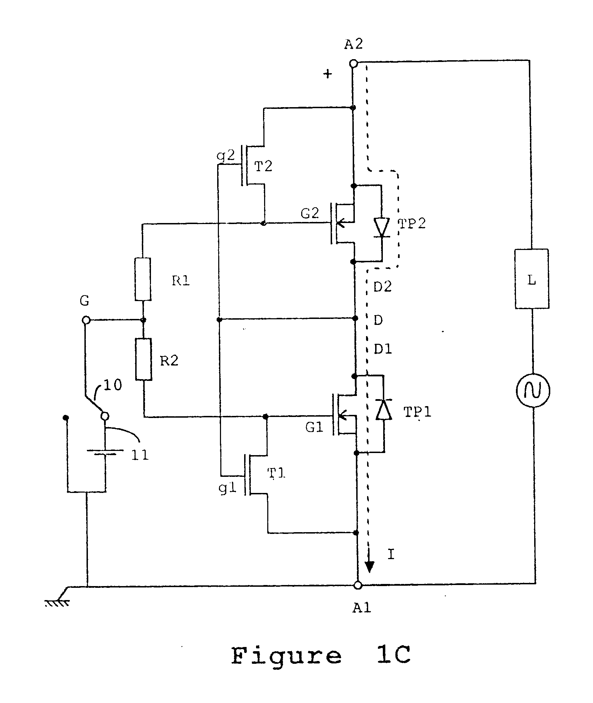

Dans ce cas, on part de la situation représentée en figure 1B et l'on commute le commutateur 10 de la tension de référence à une tension positive, par exemple de l'ordre de 10 volts, par rapport à cette tension de référence. Ceci ne change rien à l'état de fonctionnement illustré. Seul le courant de fuite augmente un peu puisque le transistor T2 était conducteur et que la tension sur son drain augmente. C'est seulement quand la tension appliquée sur la borne A2 s'inverse (figure 1C) que la situation se modifie. En effet, dans ce cas, le transistor auxiliaire T2 se bloque du fait de l'inversion de la polarité à ses bornes et le transistor TP1 qui reçoit sur sa grille une tension de 10 volts devient conducteur. Le transistor T1 est alors bloqué étant donné que sa tension grille/source est de l'ordre de R_{ON}I, inférieure à sa tension de seuil.

Selon une caractéristique importante de l'invention, il faut noter que, si le courant dans le circuit augmente de façon importante, par exemple parce que la charge s'est mis en court-circuit, la chute de tension R_{ON}I dans le transistor de puissance TP1 deviendra supérieure à la tension de seuil V_{TH1} du transistor auxiliaire T1 et que celui-ci deviendra alors conducteur et bloquera le transistor TP1. Ainsi, en choisissant convenablement la tension de seuil du transistor T1, on dispose d'un commutateur à sécurité intrinsèque qui se bloque automatiquement en cas de court-circuit dans la charge.

La figure 2 résume par les courbes GC et IC le fonctionnement du commutateur bidirectionnel selon l'invention dans le cas qui vient d'être décrit : si un ordre de fermeture est donné pendant une alternance positive entre les instants t0 et t1, le commutateur bidirectionnel commence à laisser passer un courant de charge IC à partir du passage au zéro de tension suivant (instant t1).

### 4) Application d'un ordre de fermeture pendant une alternance positive.

En ce cas, on part de la situation représentée en figure 1A. Le commutateur est bloqué et la tension sur la borne A2 est sensiblement la tension positive du réseau. Quand la borne de commande passe du potentiel de référence à un potentiel positif, par exemple 10 V, par rapport à ce potentiel de référence, le transistor T2 reste passant tant que la tension du réseau est supérieure à la valeur de la source de tension 11 par exemple 10 V (en fait une valeur un peu supérieure puisqu'il faut tenir compte de la tension de seuil du transistor T2 et de la chute de tension directe dans la diode parallèle du transistor de puissance TP2). A ce moment (figure 1D), le transistor T2 se bloque et une tension de 10 V est alors appliquée sur la borne de grille G2 du transistor TP2 qui devient passant dès que la borne A2 devient suffisamment négative par rapport à la borne A1. Le transistor T2 quant à lui reste bloqué à condition que sa tension de seuil soit inférieur à la chute de tension R_{ON}I aux bornes du transistor TP2.

On notera que dans ce cas aussi, si jamais la chute de tension R_{ON}I augmente par suite d'une augmentation importante du courant I, par exemple en cas de court-circuit, le transistor T2 devient passant et bloque le transistor TP2. Ainsi, comme dans le cas d'une conduction pendant une alternance positive, la conduction pendant une alternance négative présente une caractéristique de sécurité intrinsèque contre des court-circuits dans la charge.

La figure 2 représente par la façon symbolique par les courbes GD et ID le fait que, quand la tension GD sur la grille de commande passe à haut niveau, le courant dans le commutateur bidirectionnel ne commence à passer qu'après l'inversion de polarité suivante de la tension du réseau.

### EXEMPLE DE REALISATION

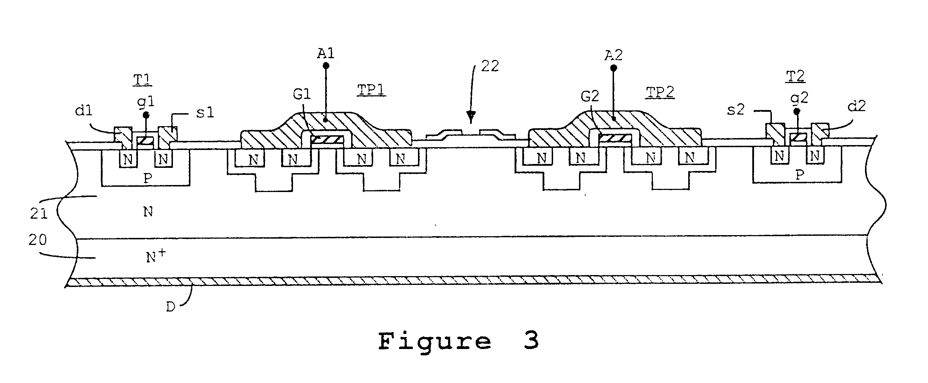

La figure 3 représente très schématiquement une vue en coupe d'un exemple de structure selon la présente invention. Comme cela est classique dans la représentation des circuits intégrés, on notera que cette figure n'est pas représentée à l'échelle et notamment que les épaisseurs des couches sont dessinées arbitrairement dans le but de faciliter la lecture de la figure.

Dans cette vue en coupe, les diverses électrodes portent les références qu'elles ont en figure 1A. La structure est réalisée dans un substrat comprenant une couche 20 de type N+ et une couche 21 de type N faiblement dopée. Dans cette couche 21 sont formés de façon classique les deux transistors de puissance TP1 et TP2, ici du type vertical à canal diffusé, dont les électrodes de source sont reliées aux bornes A1 et A2.

Les transistors auxiliaires T1 et T2 sont réalisés de façon classique sous forme de transistors MOS latéraux dans des caissons P formés dans la couche 21. La connexion entre les bornes g1 et g2 et la face arrière qui constitue la borne de drain D et n'est pas connectée vers l'extérieur peut être réalisée au niveau des bornes du dispositif ou bien les électrodes g1 et g2 peuvent être connectées à un caisson N+ à diffusion profonde formé dans la couche 21 et donc sensiblement au même potentiel que l'électrode de drain D. Il est peu important que cette connexion soit légèrement résistive puisque pratiquement aucun courant ne circule entre les électrodes g1 et D et g2 et D, respectivement.

On a également représenté en figure 3 des plaques de champ dans la zone 22 séparant les deux transistors de puissance. D'autres moyens classiques permettant d'étaler les lignes de champ ou d'éviter d'une autre manière l'influence de l'un des transistors de puissance sur l'autre pourraient être utilisés. Comme cela est usuel, on n'a représenté dans la vue en coupe partielle de la figure 3 qu'une cellule de transistor de puissance pour chacun des transistors TP1 et TP2. En fait, comme cela est classique dans la technologie des transistors de puissance de type MOS diffusé, un très grand nombre de cellules sera utilisé pour constituer chacun des transistors TP1 et TP2.

Il apparaîtra à l'homme de l'art que le commutateur bidirectionnel selon la présente invention peut être mis en oeuvre dans d'autres technologies que celle illustrée en figure 3, la plupart des technologies de transistors MOS de puissance se prêtant à réaliser des transistors de puissance à drain commun.

Bien entendu, diverses variantes et améliorations peuvent être apportées au schéma de base des figures 1A à 1D pour améliorer ou modifier certaines caractéristiques du commutateur bidirectionnel selon la présente invention.

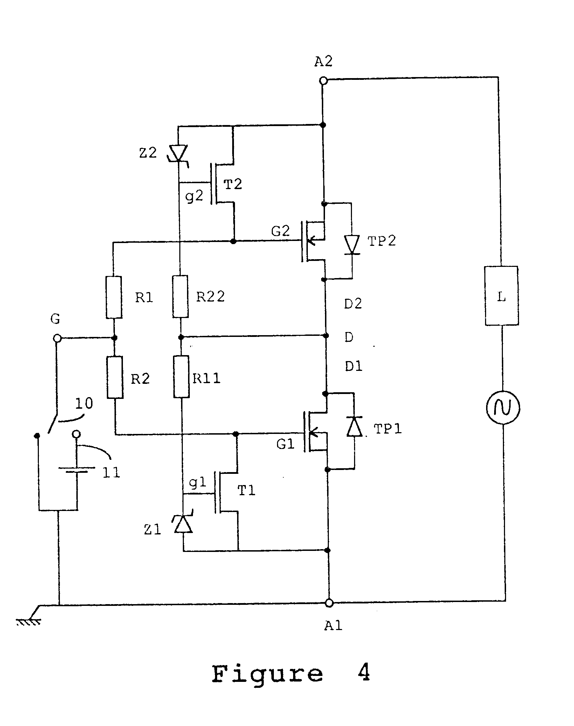

Par exemple, comme le représente la figure 4, pour éviter que la tension du réseau puisse être appliquée entre grille et source des divers transistors MOS T1, T2, TP1 et TP2, il sera simple dans les technologies courantes de rajouter une diode zener, Z1, Z2, entre chaque grille et chaque source, une résistance de valeur relativement élevée R11, R22, étant insérée entre les grilles des transistors auxiliaires T1 et T2 et le drain commun des transistors TP1 et TP2.

De même, selon la présente invention, les transistors de puissance TP1 et TP2, au lieu d'être des transistors MOS classiques, peuvent être des composants du type transistors à commande par grille isolée (IGT), ce qui signifie technologiquement, si l'on se reporte à la figure 3, qu'une couche de type P est formée sur la face inférieure du composant. Egalement, les transistors MOS de puissance peuvent être combinés à des transistors bipolaires intégrés dans la même puce pour former des combinaisons de type Darlington MOS-bipolaire, le collecteur de chaque transistor bipolaire de puissance de type NPN étant connecté au drain de chacun des transistors MOS, les bases des transistors bipolaires étant connectées aux sources des transistors TP1 et TP2, une résistance série étant rajoutée entre la source de chaque MOS et le point de connexion avec la source de chaque transistor auxiliaire, l'émetteur de chaque transistor bipolaire étant connecté à ce point de raccordement.

Ainsi, la présente invention propose un commutateur bidirectionnel monolithique présentant notamment les caractéristiques et avantages suivants :
- commande par une tension, c'est-à-dire faible consommation de courant de commande,
- possibilité d'ouverture à tout moment du cycle,
- fermeture seulement lors des passages à zéro de la tension aux bornes,
- ouverture automatique en cas de court-circuit dans la charge,
- parfaite symétrie entre ses bornes principales,
- possibilité d'intégrer des fonctions complexes sur la puce de circuit intégré comprenant le commutateur bidirectionnel, par exemple des fonctions logiques de commande et des fonctions de protection.

## Revendications

1. Commutateur statique bidirectionnel réalisé sous forme monolithique, comprenant :
- deux transistors de puissance principaux (TP1, TP2) à conduction en inverse reliés par leurs premières électrodes principales (D1, D2) non-référencées à leurs bornes de commande et dont les deuxièmes électrodes principales (S1, S2) référencées à leurs bornes de commande constituent les bornes principales (A1, A2) du commutateur, et
- deux résistances de valeur élevée (R1, R2), respectivement connectées entre la borne de commande (G1, G2) de chaque transistor de puissance et la borne de commande (G) du commutateur statique,
caractérisé en ce qu'il comprend deux transistors MOS auxiliaires (T1, T2) dont chacun est connecté par ses bornes principales entre la deuxième borne principale (A1, A2) et la borne de commande (G1, G2) de chaque transistor de puissance, les grilles (g1, g2) de ces transistors MOS auxiliaires étant reliées à la première électrode principale commune (D) des transistors de puissance.

2. Commutateur statique selon la revendication 1, caractérisé en ce qu'il comprend des moyens (10, 11) pour connecter sa borne de commande (G) ou bien à l'une des électrodes principales pour fixer un ordre d'ouverture ou bien à un potentiel positif par rapport à cette électrode principale pour fixer un ordre de fermeture.

3. Commutateur statique selon la revendication 1, caractérisé en ce que les transistors principaux sont des transistors MOS de puissance verticaux dont la première électrode principale est le drain et dont la deuxième électrode principale est la source.

4. Commutateur statique selon la revendication 3, caractérisé en ce que la tension de seuil des transistors MOS auxiliaires est choisie inférieure à la tension de seuil des transistors MOS de puissance diminuée d'une chute de tension en direct de diode.

5. Commutateur statique selon la revendication 3, caractérisé en ce que des translateurs de tension (R11, R22) sont insérés en série avec les grilles des transistors auxiliaires entre ces grilles et leur connexion commune au drain des transistors de puissance.

6. Commutateur statique selon la revendication 3, caractérisé en ce que des diodes zener (Z1, Z2) sont disposées entre grille et source de chacun des transistors de auxiliaires, et une résistance (R11, R22) entre chaque grille de transistor auxiliaire et le drain commun des transistors de puissance.

7. Commutateur statique selon la revendication 3, caractérisé en ce que les transistors de puissance sont associés en montage Darlington à des transistors bipolaires.

8. Commutateur statique selon la revendication 1, caractérisé en ce que les transistors de puissance sont du type transistors bipolaires à commande par grille isolée.

## Claims

1. A bidirectional monolithic solid-state switch, comprising:
- two main power transistors (TP1, TP2), conductive in reverse polarization, connected by their first main electrodes (D1, D2) not referenced to their control terminals, their second main electrodes (S1, S2), referenced to their control terminals, constituting the main terminals (A1, A2) of the switch, and
- two high-value resistors (R1, R2), respectively connected between the control terminal (G1, G2) of each power transistor and the control terminal (G) of the static switch,
characterized in that it comprises two auxiliary MOS transistors (T1, T2), each of which is connected by its main terminals between the second main terminal (A1, A2) and the control terminal (G1, G2) of each power transistor, the gates (g1, g2) of those auxiliary MOS transistors being connected to the first common main electrode (D) of the power transistors.

2. A solid-state switch according to claim 1, characterized in that it comprises means (10, 11) for connecting its control terminal (G) either to one of the main electrodes in order to set a switching-off order or to a voltage, positive with respect to this main electrode, in order to set a switching-on order.

3. A solid-state switch according to claim 1, characterized in that the main transistors are vertical power MOS transistors, the first main electrode of which is the drain and the second main electrode is the source.

4. A solid-state switch according to claim 3, characterized in that the threshold voltage of the auxiliary MOS transistors is selected lower than the threshold voltage of the power MOS transistors minus a forward diode voltage drop.

5. A solid-state switch according to claim 3, characterized in that voltage shifters (R11, R22) are serially connected with the gates of the auxiliary transistors between those gates and their common connection to the drain of the power transistors.

6. A solid-state switch according to claim 3, characterized in that Zener diodes (Z1, Z2) are arranged between the gate and source of each of the auxiliary transistors, and a resistor (R11, R22) is integrated between each auxiliary transistor gate and the common drain of the power transistors.

7. A solid-state switch according to claim 3, characterized in that the power transistors are associated with bipolar transistors in a Darlington circuit.

8. A solid-state switch according to claim 1, characterized in that the power transistors are bipolar transistors of the type controlled by an insulated gate.

## Patentansprüche

1. Monolithischer statischer Zweiwegschalter mit
- zwei Haupt-Leistungstransistoren (TP1, TP2), die in Gegenrichtung gepolt über ihre beiden ersten Hauptelektroden (D1, D2), die nicht auf ihre Steueranschlüsse bezogen sind, miteinander verbunden sind und deren zweite Hauptelektroden (S1, S2), die auf ihre Steueranschlüsse bezogen sind, die Hauptanschlüsse (A1, A2) des Schalters bilden, und mit
- zwei Widerständen (R1, R2) mit hohem Widerstandswert, die jeweils zwischen dem Steueranschluß (G1, G2) eines jeden Leistungstransistors und dem Steueranschluß (G) des statischen Schalters gelegen sind,
dadurch gekennzeichnet, daß der Schalter zwei MOS-Hilfstransistoren (T1, T2) aufweist, von denen jeder über seinen Hauptanschluß zwischen dem zweiten Hauptanschluß (A1, A2) und dem Steueranschluß (G1, G2) eines jeden Leistungstransistors gelegen ist, wobei die Gitter (g1, g2) dieser MOS-Hilfstransistoren an de gemeinsamen Punkt (D) der ersten Hauptelektroden der Leistungstransistoren angeschlossen ist.

2. Statischer Schalter nach Anspruch 1, dadurch gekennzeichnet, daß er eine Einrichtung (10, 11) aufweist zum Verbinden seines Steueranschlusses (G) entweder mit einer der Hauptelektroden, um einen Öffnungszustand festzulegen, oder mit einem in bezug zu dieser Hauptelektrode positiven Potential , um einen Schließzustand festzulegen.

3. Statischer Schalter nach Anspruch 1, dadurch gekennzeichnet, daß die Haupttransistoren MOS-Vertikal-Leistungstransistoren sind, deren erste Hauptelektrode die Drain und deren zweite Hauptelektrode die Source ist.

4. Statischer Schalter nach Anspruch 3, dadurch gekennzeichnet, daß die Schwellenspannung der MOS-Hilfstransistoren niedriger als die Schwellenspannung der MOS-Leistungstransistoren vermindert um den direkten Spannungsabfall einer Diode gewählt ist.

5. Statischer Schalter nach Anspruch 3, dadurch gekennzeichnet, daß Spannungsübertrager (R11, R12) in Serie mit den Gittern der Hilfselektroden zwischen diese Gitter geschaltet und mit ihrem gemeinsamen Verbindungspunkt mit der Drain der Leistungstransistoren verbunden sind.

6. Statischer Schalter nach Anspruch 3, dadurch gekennzeichnet, daß Zenerdioden (Z1, Z2) zwischen Gitter und Source jedes Hilfstransistors und ein Widerstand (R11, R12) zwischen jedes Gitter der Hilfstransistoren und den gemeinsamen Punkt der Drain-Elektroden der Leistungstransistoren geschaltet sind.

7. Statischer Schalter nach Anspruch 3, dadurch gekennzeichnet, daß die Leistungstransistoren in Darlington-Schaltung mit bipolaren Transistoren angeordnet sind.

8. Statischer Schalter nach Anspruch 1, dadurch gekennzeichnet, daß die Leistungstransistoren bipolare Transistoren mit isoliertem Steuergitter sind.
